# EUROPÄISCHE PATENTSCHRIFT

(11) **EP 1 866 728 B1**
(45) Veröffentlichungstag und Bekanntmachung des Hinweises auf die Patenterteilung: **16.06.2010**
(21) Anmeldenummer: 06707395.7
(22) Anmeldetag: 03.03.2006
(51) Int. Cl.: G06F 1/20, H01L 23/34, H05K 7/20

(54) **KÜHLEINHEIT**
COOLING UNIT
UNITE DE REFROIDISSEMENT

(30) Priorität: 08.04.2005 DE 102005016115; 21.11.2005 DE 202005018284 U
(43) Veröffentlichungstag der Anmeldung: 19.12.2007
(73) Patentinhaber: Rittal GmbH & Co. KG, 35745 Herborn (DE)
(72) Erfinder: KRAMER, Tim, 35606 Solms (DE)
(74) Vertreter: Fleck, Hermann-Josef
(86) Internationale Anmeldenummer: PCT/EP2006/001931
(87) Internationale Veröffentlichungsnummer: WO 2006/105834

(56) Entgegenhaltungen:
- DE-A1-102004 055 815
- US-A1- 2002 070 006
- US-A1- 2003 042 003

## Beschreibung

Die Erfindung bezieht sich auf eine Kühleinheit zum Einbau in einem Gehäuse, insbesondere Schaltschrank, mit einer zur Aufnahme von elektrischen Baugruppen ausgebildeten Montageplatte, die mindestens einen von einer Kühlflüssigkeit durchströmten oder zu durchströmenden Kühlkanal aufweist und an der zum Kühlen von in dem Gehäuse durch Verlustwärme anfallender Warmluft eine Luftkühleinheit mit einem Gebläse vorhanden ist, mit welchem die Warmluft zum Abkühlen flächig entlang der Montageplatte geführt ist.

Eine Kühleinheit dieser Art ist in der US 2002/070006 A1 angegeben. Bei dieser bekannten Kühleinheit sind auf einer Kühlplatte, die von flüssigkeitsleitenden Kühlkanälen durchzogen ist, wärmeproduzierende elektrische Bauelemente hoher Verlustleistung angeordnet. Auf der Seite der Bauelemente sind außerdem einen Luftstrom erzeugende Ventilatoren sowie Kühlrippen positioniert.

Eine weitere Kühleinheit in Form einer Kühlplatte mit Montagemitteln auf einer flachen Außenseite ist in der DE 10 2004 055 815 A1 angegeben. Die Montagemittel umfassen parallel zueinander verlaufende hinterschnittene Nuten und darin einsetzbare Befestigungselemente, mit denen über weitere Montageelemente Verlustwärme produzierende elektrische oder elektronische Baugruppen, wie z.B. Frequenzumformer, auf der Flachseite der Kühlplatte anbringbar sind. In der Kühlplatte sind von einem flüssigen Kühlmittel durchströmte Kühlkanäle ausgebildet, die über Anschlussleitungen vorzugsweise an außerhalb des Gehäuses bzw. Schaltschrankes angeordnete Kühlaggregate, beispielsweise eine Rückkühlanlage, angeschlossen sind. Je nach Dichte der gewundenen Kühlkanäle und Wärmetransportfähigkeit des Kühlmittels sowie auch Leitfähigkeit der Kühlplatte und weiterer vorgebbarer Parameter kann mit einem solchen Aufbau eine hohe Kühlleistung bei raumsparender, kompakter Anordnung und vielseitigen Montagemöglichkeiten erreicht werden. Für weitere Verlustwärme produzierende Baugruppen in dem Gehäuse sind weitere Kühlaggregate vorgesehen. Insgesamt ist für die Kühlung der Umgebungsluft in dem Gehäuse bzw. Schaltschrank ein relativ hoher Aufwand zu betreiben, wobei Kühlaggregate gegebenenfalls mit Lüftern an geeigneten Stellen einzubauen sind.

Der Erfindung liegt die Aufgabe zugrunde, eine Lösung zu finden, mit der der Aufwand zum Kühlen von Umgebungsluft in einem Gehäuse verringert wird.

Diese Aufgabe wird mit den Merkmalen des Anspruches 1 gelöst. Hierbei ist vorgesehen, dass die Montageplatte auf ihrer einen, der vorderen Flachseite mit Befestigungsmitteln zum Anbringen der zu kühlenden Baugruppen ausgebildet ist und die Luft entlang der von der vorderen Flachseite abgekehrten Rückseite geführt ist.

Hierbei wird die ohnehin vorhandene und in dem Gehäuse angebrachte Montageplatte mehrfach nutzbar, nämlich zum Kühlen gegebenenfalls montierter elektrischer oder elektronischer Baugruppen und entfernter, Verlustwärme produzierender Komponenten durch Kühlung der Warmluft, wobei die guten Wärmeübertragungseigenschaften und große Kühlfläche der von der Kühlflüssigkeit durchströmten Montageplatte vorteilhaft ausgenutzt werden. Dabei besteht eine für den Aufbau und die Anordnung in einem Gehäuse günstige Ausführungsform darin, dass die Montageplatte auf ihrer einen, der vorderen Flachseite mit Befestigungsmitteln zum Anbringen der zu kühlenden Baugruppen ausgebildet ist und die Luft entlang der von der vorderen Flachseite abgekehrten Rückseite geführt ist.

Eine gezielte Luftführung entlang der Kühlfläche wird dadurch begünstigt, dass die Luftkühleinheit einen flächig entlang der Montagplatte angeordneten Luftführungsabschnitt aufweist.

Eine vorteilhafte, breitflächige Anbringung der Luftkühleinheit und ungehinderte, eindeutige Luftführung wird weiterhin dadurch begünstigt, dass der Luftführungsabschnitt schachtartig ausgebildet ist und sich im Wesentlichen über die gesamte Breite oder Länge der Montageplatte erstreckt. Beispielsweise kann der schachtartige Luftführungsabschnitt einen flachen, rechteckförmigen Querschnitt mit großer Anlagefläche bzw. Öffnungsseite zur Kühlfläche hin aufweisen.

Verschiedene Ausgestaltungsvarianten für die Luftführung und zum Erreichen einer Abkühlung bestehen darin, dass die Luft längs oder quer bezüglich der Kühlkanäle entlang der Montageplatte geführt ist. Bei Führung der Luft in Querrichtung zu den Kühlkanälen kann dabei die Einströmseite der Warmluft im Bereich der Kaltseite der Kühlflüssigkeit oder der Warmseite gewählt sein.

Für einen wirksamen Wärmeaustausch mit der gekühlten Montageplatte kann weiterhin vorgesehen sein, dass in dem Luftführungsabschnitt in Strömungsrichtung der Luft verlaufende Kühlrippen angeordnet sind. Hierbei können die Kühlrippen in dem Luftführungsabschnitt separat ausgebildet oder einstückig auf der Montageplatte ausgeformt sein und in den Luftführungsabschnitt ragen.

Weitere günstige Ausgestaltungsmöglichkeiten für einen kompakten Aufbau bzw. unterschiedliche Zuordnungsmöglichkeiten zwischen Luftkühleinheit und Montageplatte ergeben sich dadurch, dass die Montageplatte integraler Bestandteil der Luftkühleinheit ist oder dass der Luftführungsabschnitt auf einer Flachseite der Montageplatte aufgebracht ist.

Weitere günstige Ausgestaltungsvarianten für eine flächige Luftführung bzw. eine hohe Strömungsleistung ergeben sich dadurch, dass das Gebläse als Axial- oder Radiallüfter ausgebildet ist und sich mit seiner Ausströmseite entlang einem Rand der Montageplatte erstreckt.

Die Herstellung und die Funktionsfähigkeit werden dadurch begünstigt, dass der mindestens eine Kühlkanal mit einer eingesetzten Leitung versehen ist, dass die Leitung in mindestens einen von der flachen Seite (vorzugsweise der Rückseite) eingefrästen, mäanderförmig verlaufenden Aufnahmekanal eingepresst und darin festgelegt ist und dass die betreffende Seite anschließend plan gearbeitet ist. Die Leitung kann hierbei mittels Füllmaterialien unter guter Leitfähigkeit eingebracht werden.

Für die Montage zu kühlender Baugruppen auf der Montageplatte sind ferner die Maßnahmen vorteilhaft, dass zumindest eine Flachseite (vorzugsweise der Vorderseite) der Montageplatte mit zueinander parallel verlaufenden hinterschnittenen Nuten und/oder mit Befestigungsbohrungen versehen ist.

Die Erfindung wird nachfolgend anhand von Ausführungsbeispielen unter Bezugnahme auf die Zeichnungen näher erläutert. Es zeigen:
- Fig. 1A und 1B: eine Kühleinheit mit Montageplatte und Luftkühleinheit in schematischer perspektivischer Ansicht von der Rückseite bzw. Vorderseite,
- Fig. 2A und 2B: ein weiteres Ausführungsbeispiel einer Kühleinheit in schematischer perspektivischer Ansicht von der Vorderseite bzw. Rückseite,
- Fig. 3: eine Draufsicht auf die Rückseite der Montageplatte in schematischer Ansicht und
- Fig. 4: einen Querschnittsbereich der Montageplatte nach Fig. 3 in vergrößer- ter Darstellung.

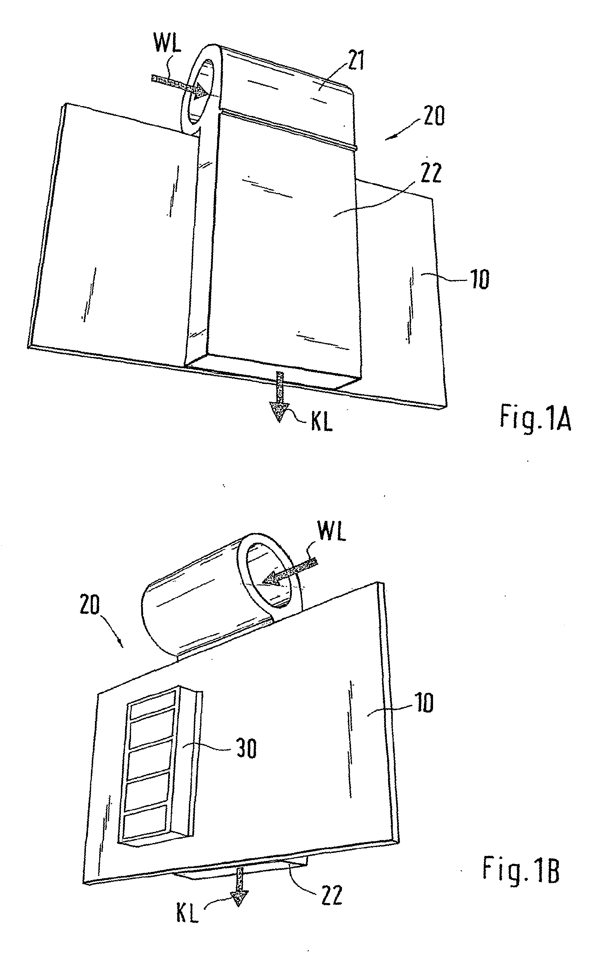

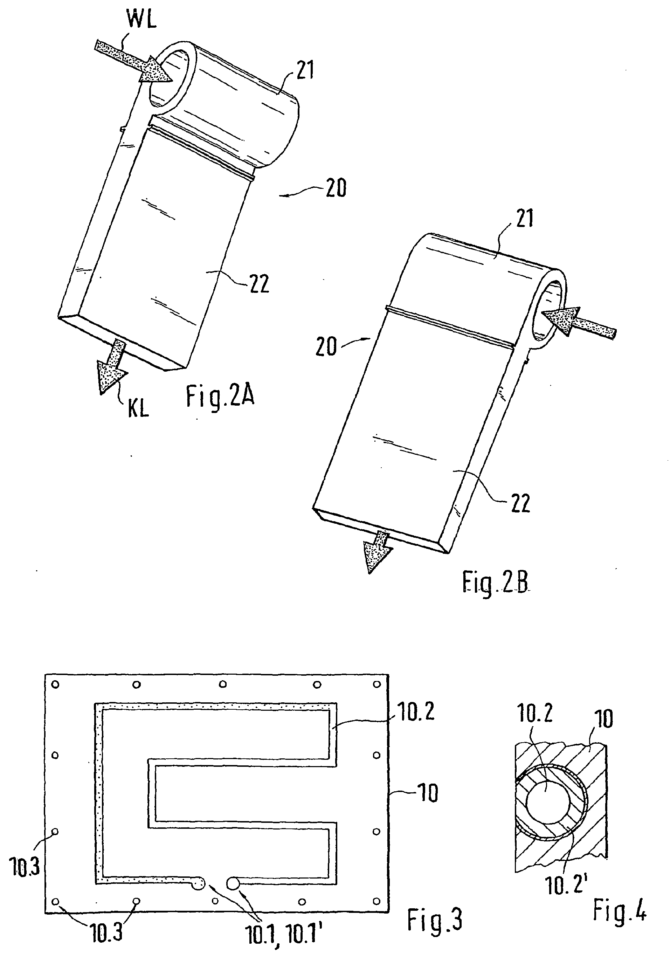

Eine in den Fig. 1A und 1B gezeigte Kühleinheit aus einer als Kühlplatte ausgebildeten Montageplatte 10 und einer Luftkühleinheit 20 mit einem am oberen Rand der Montageplatte 10 angeordneten Gebläse 21 und einem flach auf der Rückseite der Montageplatte 10 in gutem Wärmeleitkontakt aufgebrachten flachen Luftführungsabschnitt 22 trägt auf ihrer Vorderseite eine elektrische oder elektronische Baugruppe 30, z.B. einen relativ hohe Verlustleistung produzierenden Frequenzumformer oder ein elektromechanisches Bauteil oder dgl. Die Baugruppe 30 ist in engem wärmeleitendem Kontakt auf der vorderen Flachseite der Montageplatte 10 aufgebracht und beispielsweise über hinterschnittene T-Nuten und darin eingesetzte Befestigungselemente gesichert, wie in der eingangs genannten DE 10 2004 055 815 A1 näher angegeben. Parallele Montagenuten und daran festgelegte Montageleisten ergeben dabei vielfältige Anordnungsmöglichkeiten. In der z.B. aus Kupfer oder Aluminium oder einem anderen gut wärmeleitfähigen Material bestehenden Montageplatte 10 ist zur Abführung der anfallenden Verlustwärme mindestens ein mehr oder weniger dicht geschlängelter Luftführungskanal eingebracht, der von einer Kühlflüssigkeit durchströmt wird. Der in den Fig. 3 und 4 gezeigte Kühlkanal 10.2 ist über einen Zuströmanschluss 10.1 und einen Abströmanschluss 10.1' mit einer Anschlussleitung versehen, über die die gekühlte Kühlflüssigkeit zugeführt bzw. die erwärmte Kühlflüssigkeit abgeführt wird. Günstig ist es, die Kühlflüssigkeit in einer entfernten Rückkühlanlage abzukühlen, so dass das Schaltschrankinnere bzw. die unmittelbare Schaltschrankumgebung durch die abgeführte Verlustwärme nicht belastet wird.

Auch ergeben sich vorteilhafte Steuerungs- oder Regelungsmöglichkeiten für die Kühlleistung.

Bei dem in Fig. 4 in einer Querschnittsdarstellung gezeigten Aufbau ist der Kühlkanal 10.2 in der Weise ausgestaltet, dass von der einen flachen Seite, beispielsweise der Rückseite der Montageplatte 10, zunächst nutartige Kanäle eingefräst sind, in die eine oder mehrere Leitungen 10.2' eingepresst sind, um einerseits einen guten Wärmekontakt der an sich ebenfalls gut wärmeleitfähigen Leitungen 10.2' und außerdem eine sichere Befestigung zu gewährleisten. Die Öffnung des nutartigen Kanals zur flachen Seite hin ist schmäler als ihr Inneres, so dass die eingedrückte Leitung 10.2' sicher gehalten ist. Überstände der Leitung 10.2' auf der flachen Außenseite der Montageplatte 10 werden nach ihrem Einbringen plan gearbeitet, wozu die Leitungen 10.2' einen ausreichend dicken Wandbereich besitzen. Ferner werden entstehende Lücken oder Unebenheiten z.B. mittels Leitklebers oder ähnlicher geeigneter Materialien verfüllt und geglättet. Die Montageplatte 10 kann z.B. mittels in ihrem Randbereich angeordneter Befestigungslöcher 10.3 an geeigneten Montageprofilen oder Wandabschnitten im Gehäuse bzw. Schaltschrank an geeigneter Stelle angebracht werden, wobei die den Luftführungsabschnitt 22 tragende Rückseite einen entsprechenden Abstand für den Luftführungsabschnitt 22 gegenüber Wandabschnitten oder Montageteilen des Gehäuses freilässt.

Wie aus den Fig. 1A, 1B ersichtlich, ist das z.B. als Radialgebläse ausgebildete Gebläse 21 entlang dem oberen Rand der Montageplatte 10 angeordnet und besitzt einen breiten Ausströmbereich, der in den entsprechend breit ausgelegten, schachtartig ausgebildeten Luftführungsabschnitt 22 übergeht. Der Luftführungsabschnitt 22 besitzt einen flachen rechteckförmigen Querschnitt und liegt großflächig z.B. mit eine Breite von mehr als 10 oder 20 cm an der Rückseite der Montageplatte 10 an, so dass die einströmende Warmluft WL großflächig und in möglichst geringem Abstand mit schmalem Strömungsquerschnitt z.B. in einer Schichtdicke von weniger als 10 oder 5 cm an der Kühlfläche der Montageplatte 10 vorbeigeführt wird. Dabei kann die Strömungsrichtung der Luft quer oder längs bezüglich der Hauptanordnungsrichtung der Kühlkanäle 10.2 verlaufen, wobei die Kaltseite der Kühlflüssigkeit in der Nähe der einströmenden Warmluft oder in der Nähe der aus dem Luftführungsabschnitt 22 ausströmenden Kühlluft KL angeordnet sein kann. Bei einer alternativen Anordnung verläuft die Luftströmung in Längsrichtung zu den Kühlkanälen 10.2.

Der Luftführungsabschnitt 22 kann in sich im Querschnitt rundum geschlossen aus gut wärmeleitfähigem Material hergestellt sein oder U-förmigen Querschnitt mit zur Flachseite der Montageplatte 10 gerichteter offener U-Seite ausgebildet sein, so dass die Luft unmittelbar entlang der kühlenden Flachseite der Montageplatte 10 entlang strömt. Auch können in den Luftführungsabschnitt 22 in Strömungsrichtung der Luft verlaufende Kühlrippen angeordnet sein, die bei U-förmiger Gestaltung des Luftführungsabschnittes 22 auch einstückig auf der Montageplatte 10 angeformt sein können.

Eine andere Ausgestaltungsvariante der Kühleinheit besteht darin, dass der flach ausgebildete Luftführungsabschnitt 22 selbst integral mit der Montageplatte 10 versehen ist, wie in den Fig. 2A und 2B gezeigt. Diese Ausgestaltung ergibt einen besonders kompakten Aufbau, wobei die Führung der zu kühlenden Luft günstig für eine hohe Kühlleistung angepasst werden kann, wobei sich der Strömungsquerschnitt praktisch entlang der gesamten Kühlfläche erstreckt.

Die vorteilhaft nach unten abgegebene Kühlluft KL steht wieder zur Kühlung in dem Gehäuse bzw. Schaltschrank vorhandener Baugruppen bzw. zu kühlender Komponenten zur Verfügung.

## Patentansprüche

1. Kühleinheit zum Einbau in einem Gehäuse, insbesondere Schaltschrank, mit einer zur Aufnahme von elektrischen Baugruppen ausgebildeten Montageplatte (10), die mindestens einen von einer Kühlflüssigkeit durchströmten oder zu durchströmenden Kühlkanal (10.2) aufweist und an der zum Kühlen von in dem Gehäuse durch Verlustwärme anfallender Warmluft eine Luftkühleinheit (20) mit einem Gebläse (21) vorhanden ist, mit welchem die Warmluft zum Abkühlen flächig entlang der Montageplatte (10) geführt ist,
**dadurch gekennzeichnet,**
**dass** die Montageplatte (10) auf ihrer einen, der vorderen Flachseite mit Befestigungsmitteln zum Anbringen der zu kühlenden Baugruppen ausgebildet ist und die Warmluft entlang der von der vorderen Flachseite abgekehrten Rückseite geführt ist.

2. Kühleinheit nach Anspruch 1,
**dadurch gekennzeichnet,**
**dass** die Luftkühleinheit (20) einen flächig entlang der Montagplatte (10) angeordneten Luftführungsabschnitt (22) aufweist.

3. Kühleinheit nach Anspruch 2,
**dadurch gekennzeichnet,**
**dass** der Luftführungsabschnitt (22) schachtartig ausgebildet ist und sich im Wesentlichen über die gesamte Breite oder Länge der Montageplatte (10) erstreckt.

4. Kühleinheit nach einem der vorhergehenden Ansprüche,
**dadurch gekennzeichnet,**
**dass** die Luft längs oder quer bezüglich der Kühlkanäle (10.2) entlang der Montageplatte (10) geführt ist.

5. Kühleinheit nach Anspruch 2 oder 3,
**dadurch gekennzeichnet,**
**dass** in dem Luftführungsabschnitt (22) in Strömungsrichtung der Luft verlaufende Kühlrippen angeordnet sind.

6. Kühleinheit nach einem der vorhergehenden Ansprüche,
**dadurch gekennzeichnet,**
**dass** die Montageplatte (10) integraler Bestandteil der Luftkühleinheit (20) ist oder
**dass** der Luftführungsabschnitt (22) auf einer Flachseite der Montageplatte (10) aufgebracht ist.

7. Kühleinheit nach einem der vorhergehenden Ansprüche,
**dadurch gekennzeichnet,**
**dass** das Gebläse (21) als Axial- oder Radiallüfter ausgebildet ist und sich mit seiner Ausströmseite entlang einem Rand der Montageplatte (10) erstreckt.

8. Kühleinheit nach einem der vorhergehenden Ansprüche,
**dadurch gekennzeichnet,**
**dass** der mindestens eine Kühlkanal (10.2) mit einer eingesetzten Leitung (10.2') versehen ist,
**dass** die Leitung (10.2') in mindestens einen von der flachen Seite eingefrästen, mäanderförmig verlaufenden Aufnahmekanal eingepresst und darin festgelegt ist und
**dass** die betreffende Seite anschließend plan gearbeitet ist.

9. Kühleinheit nach einem der vorhergehenden Ansprüche,
**dadurch gekennzeichnet,**
**dass** zumindest eine Flachseite der Montageplatte (10) mit zueinander parallel verlaufenden hinterschnittenen Nuten und/oder mit Befestigungsbohrungen versehen ist.

## Claims

1. Cooling unit for integrating into a housing, especially a control box, comprising an assembly plate (10) which is embodied in such a way as to receive electrical assemblies and comprises at least one cooling channel (10.2) through which a coolant flows or is to flow, and an air cooling unit (20) with a fan (21) is provided on the assembly plate (10) for cooling warm air arising in the housing due to dissipated heat, said fan being used to guide the warm air in planar manner along the assembly plate (10) for cooling purposes, **characterised in that** the assembly plate (10) is configured on the front flat side thereof with fastening means for mounting the assemblies to be cooled and the warm air is guided along the rear side facing away from the front flat side.

2. Cooling unit according to claim 1, **characterised in that** the air cooling unit (20) comprises an air guiding section (22) arranged in planar manner along the assembly plate (10).

3. Cooling unit according to claim 2, **characterised in that** the air guiding section (22) is configured shaft-like and extends substantially over the whole width or length of the assembly plate (10).

4. Cooling unit according to one of the preceding claims, **characterised in that** the air is guided longitudinally or transversely in relation to the cooling channels (10.2) along the assembly plate (10).

5. Cooling unit according to claim 2 or 3, **characterised in that** cooling ribs are arranged in the air guiding section (22) in the direction of flow of the air.

6. Cooling unit according to one of the preceding claims, **characterised in that** the assembly plate (10) is an integral component of the air cooling unit (20) or that the air guiding section (22) is mounted on a flat side of the assembly plate (10).

7. Cooling unit according to one of the preceding claims, **characterised in that** the fan (21) is configured as an axial flow or radial flow fan and extends with the outflow side thereof along an edge of the assembly plate (10).

8. Cooling unit according to one of the preceding claims, **characterised in that** the at least one cooling channel (10.2) is provided with an embedded conduit (10.2'), that the conduit (10.2') is pressed into at least one receptacle channel, which extends in meandering manner, and is milled out of the flat side, and is fastened therein, and that the relevant side is subsequently made flat.

9. Cooling unit according to one of the preceding claims, **characterised in that** at least one flat side of the assembly plate (10) is provided with undercut grooves extending parallel to one another and/or fastening bores.

## Revendications

1. Unité de refroidissement destinée à être intégrée dans un boîtier, notamment une armoire de commutation, comportant une platine de montage (10) réalisée pour recevoir des groupes de composants électriques, munie d'au moins un canal de refroidissement (10.2) parcouru, ou devant être parcouru par un fluide de refroidissement, et sur laquelle se trouve, en vue de refroidir de l'air chaud dégagé dans le boîtier, par de la chaleur dissipée, une unité (20) de refroidissement d'air qui est équipée d'une soufflerie (21) par laquelle l'air chaud est guidé en nappes le long de la platine de montage (10), en vue du refroidissement,
**caractérisée par le fait**
**que** ladite platine de montage (10) est dotée sur l'une de ses faces aplaties, précisément la face antérieure, de moyens de fixation affectés à l'installation des groupes de composants à refroidir, l'air chaud étant guidé le long de la face postérieure tournée à l'opposé de ladite face aplatie antérieure.

2. Unité de refroidissement selon la revendication 1,
**caractérisée par le fait**
**que** l'unité (20) de refroidissement d'air offre une région (22) de guidage d'air portant, à plat, le long de la platine de montage (10).

3. Unité de refroidissement selon la revendication 2,
**caractérisée par le fait**
**que** la région (22) de guidage d'air est de réalisation du type cheminée et s'étend, pour l'essentiel, sur l'intégralité de la largeur ou de la longueur de la platine de montage (10).

4. Unité de refroidissement selon l'une des revendications précédentes,
**caractérisée par le fait**
**que** l'air est guidé, le long de la platine de montage (10), longitudinalement ou transversalement par rapport aux canaux de refroidissement (10.2).

5. Unité de refroidissement selon la revendication 2 ou 3,
**caractérisée par le fait**
**que** des nervures de refroidissement, s'étendant dans le sens de circulation de l'air, sont disposées dans la région (22) de guidage d'air.

6. Unité de refroidissement selon l'une des revendications précédentes,
**caractérisée par le fait**
**que** la platine de montage (10) fait partie intégrante de l'unité (20) de refroidissement d'air ;
ou
**que** la région (22) de guidage d'air est implantée sur une face aplatie de ladite platine de montage (10).

7. Unité de refroidissement selon l'une des revendications précédentes,
**caractérisée par le fait**
**que** la soufflerie (21) est réalisée sous la forme d'un ventilateur axial ou radial et s'étend, par son côté sortie, le long d'un bord de la platine de montage (10).

8. Unité de refroidissement selon l'une des revendications précédentes,
**caractérisée par le fait**
**que** le canal de refroidissement (10.2), prévu au minimum, est muni d'une conduite intégrée (10.2') ;
**que** ladite conduite (10.2') est encastrée à force, avec blocage à demeure, dans au moins un canal récepteur s'étendant en forme de méandres et pratiqué, par fraisage, à partir de la face aplatie ; et
**que** ladite face est ensuite aplanie par usinage.

9. Unité de refroidissement selon l'une des revendications précédentes,
**caractérisée par le fait**
**qu'**au moins une face aplatie de la platine de montage (10) est pourvue de rainures contre-dépouillées, s'étendant avec parallélisme mutuel, et/ou de perçages de fixation.
